Europäisches Patentamt

European Patent Office

Office européen des brevets

(11) Veröffentlichungsnummer: **0 308 366**
**A1**

## (12) EUROPÄISCHE PATENTANMELDUNG

(21) Anmeldenummer: 88810546.7

(22) Anmeldetag: 12.08.88

(51) Int. Cl.⁴: **G 12 B 9/04**
F 16 B 5/00, F 16 J 15/02

(30) Priorität: 02.09.87 CH 3360/87

(43) Veröffentlichungstag der Anmeldung:
22.03.89 Patentblatt 89/12

(84) Benannte Vertragsstaaten: **DE FR GB IT SE**

(71) Anmelder: **KERN & CO. AG**
**CH-5001 Aarau (CH)**

(72) Erfinder: **Wahlen, Erika**
**Zofingerstrasse 35**
**CH-4665 Oftringen (CH)**

(74) Vertreter: **Seeger, Jan**
**c/o Kern & Co. AG**
**CH-5001 Aarau (CH)**

(54) **Dichtung.**

(57) Beim Zusammentreffen dreier Fugen zwischen drei miteinander durch Einsteck- und Aufnahmeprofile (4 - 9) verbundenen flächigen Teilen (1, 2, 3) wird eine dichte Verbindung
dadurch erreicht, dass ein Einsteckprofil (4) mit einer Nut
versehen ist und so gleichzeitig als Aufnahmeprofil für ein
weiteres Einsteckprofil (6) an einem der anderen flächigen Teile
(2) dient. (Fig. 1)

Fig.1

**Beschreibung**

**Dichtung**

Die Erfindung betrifft eine Dichtung zwischen drei aufeinandertreffenden flächenhaften Teilen.

Bekannt sind Dichtungen mit zwei miteinander in Eingriff zu bringenden länglichen Dichtungselementen, deren Querschnitte ein gegenseitiges Einrasten ermöglichen, wobei die Dichtungselemente als Einsteckelement, bzw. als Aufnahmeelement ausgebildet sind, vgl. DE-A-2904636 (Modern Precision Engineers). Bei solchen Dichtungen ergeben sich Probleme, wenn drei aufeinandertreffende Teile gegeneinander abzudichten sind, weil die Uebergänge zwischen Einsteck- und Aufnahmeelement nicht dicht sind.

Aufgabe der Erfindung ist es, eine Dichtung mit je zwei miteinander in Eingriff zu bringenden Dichtungselementen zu schaffen, welche auch eine Verbindung von drei aufeinandertreffenden Dichtungsfugen dicht verschliesst.

Diese Aufgabe wird gemäss der Erfindung durch die Merkmale des Patentanspruchs 1 gelöst. Vorteilhafte Weiterbildungen sind Gegenstand der Unteransprüche.

Ein Ausführungsbeispiel der Erfindung wird im folgenden anhand der Figuren beschrieben. Es zeigen:

Fig. 1 drei aufeinandertreffende Teile mit Dichtungsflächen in der Draufsicht,

Fig. 2 die drei Teile gemäss Fig. 1 in miteinander verbundener Lage,

Fig. 3 einen Schnitt längs der Linie A-A in Fig. 2 durch die Verbindung zweier Teile,

Fig. 4 einen Schnitt längs der Linie B-B in Fig. 2 durch die Verbindung zweier Teile,

Fig. 5 einen Schnitt längs der Linie C-C in Fig. 2 durch die Verbindung zweier Teile,

Fig. 6 einen Schnitt längs der Linie D-D in Fig. 2 durch den Verbindungsbereich dreier Teile und

Fig. 7 einen Schnitt längs der Linie E-E in Fig. 2 durch den Verbindungsbereich dreier Teile und senkrecht zur Linie D-D.

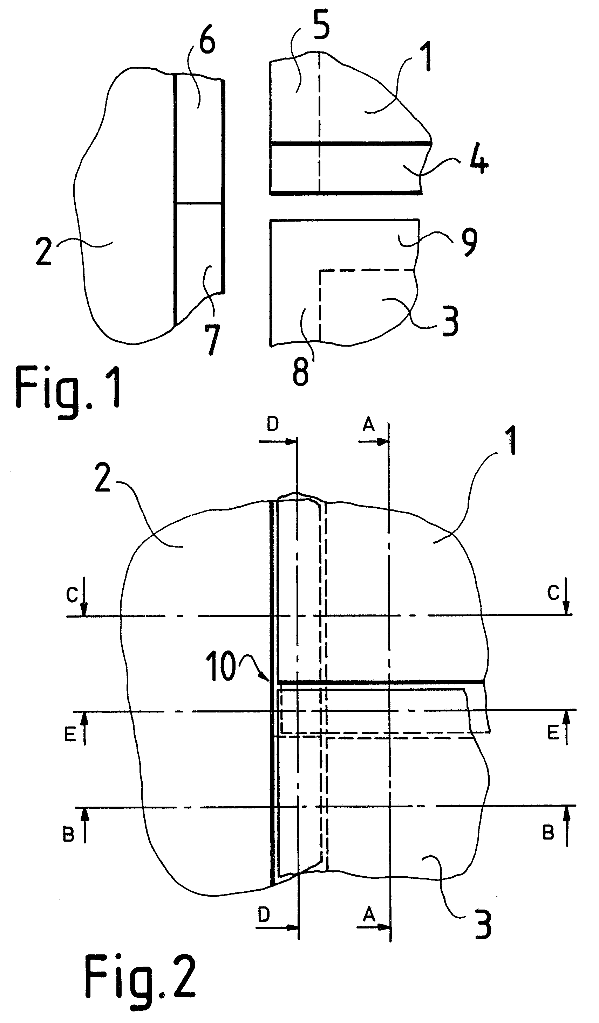

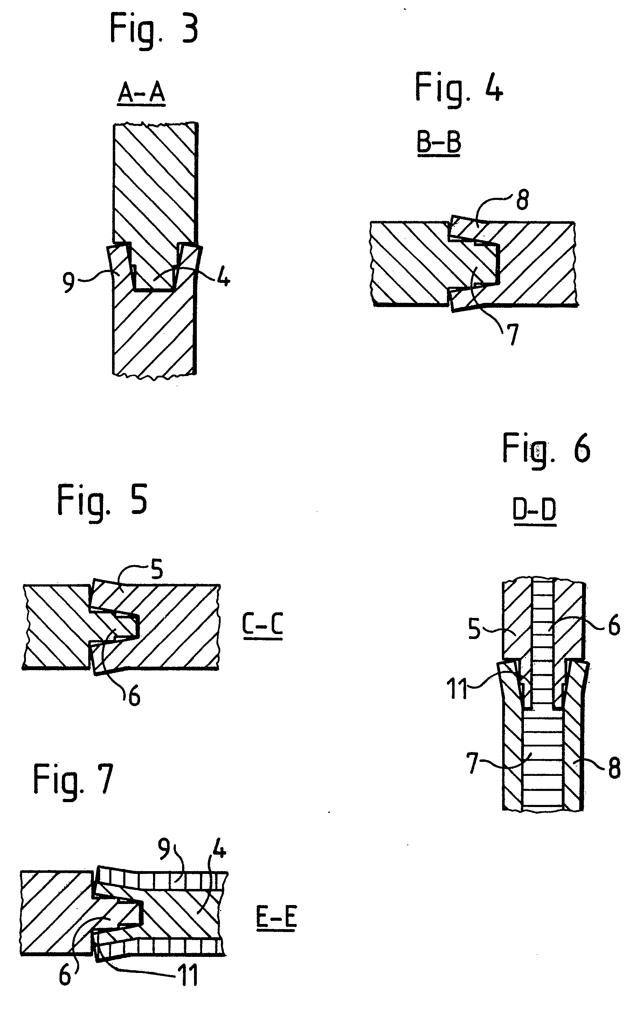

Fig. 1 zeigt drei plattenförmige Teile 1, 2, 3, welche einander mit geradlinigen Dichtungselementen zur gegenseitigen Verbindung gegenüberliegen. Das Teil 1 besitzt zur Verbindung mit Teil 3 das Dichtungselement, 4 zur Verbindung mit Teil 2 das Dichtungselement 5, das Teil 2 besitzt zur Verbindung mit Teil 1 das Dichtungselement 6, zur Verbindung mit Teil 3 das Dichtungselement 7 und das Teil 3 besitzt zur Verbindung mit Teil 2 das Dichtungselement 8 und zur Verbindung mit Teil 1 das Dichtungselement 9. Jedes Dichtungselement ist entweder als Einsteckelement oder als Aufnahmeelement zur Aufnahme eines entsprechenden Einsteckelementes ausgebildet. Wie insbesondere aus den Schnittdarstellungen der Fig. 3 - 5 ersichtlich, sind die Dichtungselemente 4, 6, 7 stegförmig als Einsteckelemente und die Dichtungselemente 5, 8, 9 U-förmig als Aufnahmeelemente ausgebildet.

Gemäss Fig. 2 sind die Teile 1, 2, 3 mit ihren Dichtungselementen 4 - 9 miteinander verbunden.

Dabei würden sich zunächst Schwierigkeiten ergeben, wenn man im Uebergangsbereich 10 zwischen Einsteckelement 4 und Aufnahmeelement 5 am Teil 1 weder Steg- noch U-Form, also eine Lücke vorsieht, weil dann hier eine undichte Stelle entsteht. Würde man in dieser Lücke den Steg 4 weiterführen, so würden sich die Stege 4 und 6 gegenüberstehen und ein Zusammenfügen der Teile 1 und 2 wäre unmöglich. Die Lösung besteht nun darin, dass man den Steg 4 so dick ausführt, dass er auch noch eine U-förmige Nut 11 aufnehmen kann, wie dies Fig. 7 zeigt. Im dargestellten Ausführungsbeispiel ist vorgesehen, dass Die Nut 11 die Fortsetzung des U-förmigen Aufnahmeelementes 5 am Teil 1 bildet und somit Nut 11 und Element 5 die gleiche Innenweite aufweisen. Die Nut 11 im stegförmigen Einsteckelement 4 kann nun das Einsteckelement 6 am Teil 2 aufnehmen, sodass sich ein problemloses Zusammenfügen der Teile 1 und 2 ergibt. Das Dichtungselement 4 am Teil 1 dient also im Uebergangsbereich 10 gleichzeitig gegenüber dem Element 9 am Teil 3 als Einsteckelement und gegenüber dem Element 6 am Teil 2 als Aufnahmeelement.

Der Schnitt gemäss Fig. 6 verdeutlicht nochmals die Lage der Dichtungselemente im Uebergangsbereich 10. Das Dichtungselement 5 am Teil 1 weist eine relativ schmale U-förmige Nut auf, in die das dazu passende Element 6 am Teil 2 eingesteckt ist. Diese Nut wird durch die Nut 11 fortgesetzt, wobei das Element 5 in das Element 4 und das Element 6 in das Element 7 jeweils am gleichen Teil 1, bzw. 2 übergeht. Wie ersichtlich ist der gesamte Uebergangsbereich 10 mit Dichtungselementen 6, 5, 9 ausgefüllt, welche einander U-förmig umschliessen und dichte Presspassungen bilden.

Ueber das beschriebene Ausführungsbeispiel hinaus umfasst die Erfindung noch weitere Varianten. So kann es zweckmässig sein, die Dicke des Einsteckelementes 6 jenseits des Uebergangsbereiches 10 wieder auf die Dicke des Einsteckelementes 7 zu vergrössern, wenn eine grosse Stabilität der Verbindung erforderlich ist. Auch ist es nicht notwendig, dass die Dichtungselemente 4 - 9 direkt an die Teile 1, 2, 3 angeformt sind. Die Elemente 4 - 9 können vielmehr als separate, insbesondere endlose und flexible Profile hergestellt und nachträglich an den Teilen 1, 2, 3 befestigt werden. Die Teile 1, 2, 3 müssen weder eben noch plattenförmig sein, hierfür können insbesondere auch Rohrenden oder radiale Rohrflansche vorgesehen sein. Eine besonders zweckmässige Verwendung ergibt sich bei der dichten Verbindung von Kunststoffteilen, welche als Verkleidungselemente von Mess- oder anderen Instrumenten dienen.

**Patentansprüche**

1. Dichtung zwischen drei aufeinandertreffenden flächenhaften Teilen (1, 2, 3), wobei jedes Teil sich jeweils in einer Längsrichtung erstreckende Dichtungselemente (4 - 9) mit in dieser Längsrichtung verlaufenden Dichtungsflächen zur abdichtenden Anlage an jeweils einem anderen Dichtungselement aufweist, jedes Dichtungselement als Einsteckelement (4, 6, 7) oder als Aufnahmeelement (5, 8, 9) ausgebildet ist und jedes Aufnahmeelement einen U-förmigen Querschnitt aufweist, der ein Ineinandergreifen mit einem zugehörigen Einsteckelement erlaubt derart, dass an jeder Seite des Einsteckelementes ein U-Schenkel anliegt, dadurch gekennzeichnet, dass in dem Bereich (10), in dem die drei Fugen zwischen den drei Teilen (1, 2, 3) aufeinandertreffen, ein Einsteckelement (4) eines ersten flächenhaften Teiles (1) seinerseits einen U-förmigen Durchbruch (11) aufweist, durch den das Einsteckelement (6) eines zweiten flächenhaften Teiles (2) hindurchführt ist derart, dass das Einsteckelement (4) des ersten Teiles (1) in diesem Bereich gleichzeitig gegenüber dem Einsteckelement (6) des zweiten Teiles (2) als Aufnahmeelement und gegenüber dem zugehörigen Aufnahmeelement (9) des dritten Teiles (3) als Einsteckelement dient.

2. Dichtung gemäss Anspruch 1, dadurch gekennzeichnet, dass das Einsteckelement (6 bzw. 7) des zweiten flächenhaften Teiles (2) in dem Bereich (10), in dem es mit dem Einsteckelement (4) des ersten flächenhaften Teiles (1) im Eingriff steht, eine wesentlich geringere Dicke aufweist, als in dem Bereich, in dem es mit dem zugehörigen Aufnahmeelement (8) des dritten Teiles (3) im Eingriff steht.

3. Dichtung gemäss Anspruch 1, dadurch gekennzeichnet, dass das zweite flächenhafte Teil (2) sowohl zur Verbindung mit dem ersten (1) als auch mit dem dritten flächenhaften Teil (3) als Dichtungselement ein Einsteckelement (6, 7) aufweist, wobei die Dicke des Einsteckelementes (6) zur Verbindung mit dem ersten Teil (1) wesentlich geringer ist, als jene des Einsteckelementes (7) zur Verbindung mit dem dritten Teil (3).

4. Dichtung nach einem der Ansprüche 1 - 3, dadurch gekennzeichnet, dass die Dichtungselemente (4 - 9) an Trennfugen einer Verkleidung eines Instrumentes vorgesehen sind.

Fig. 1

Fig.2

# Fig. 3

## A-A

9    4

# Fig. 4

## B-B

8

7

# Fig. 5

5

6

## C-C

# Fig. 6

## D-D

5    6

11

7    8

# Fig. 7

9    4

## E-E

6    11

Europäisches
Patentamt

# EUROPÄISCHER RECHERCHENBERICHT

Nummer der Anmeldung

EP 88 81 0546

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE-B-1 051 723 (BARTKEWITZ) <br> * Das ganze Dokument * <br> --- | 1 | G 12 B 9/04 <br> F 16 B 5/00 <br> F 16 J 15/02 |
| A | DE-U-7 411 554 (ETTINGER) <br> * Seite 10, Zeilen 7-19; Figur 3 * <br> --- | 1 | |
| D,A | DE-A-2 904 636 (MODERN PRECISION) <br> ----- | | |

RECHERCHIERTE SACHGEBIETE (Int. Cl.4)

B 65 D
G 12 B
H 05 K

Der vorliegende Recherchenbericht wurde für alle Patentansprüche erstellt

| Recherchenort | Abschlußdatum der Recherche | Prüfer |
|---|---|---|
| DEN HAAG | 09-12-1988 | VAN DER WAL W |

EPO FORM 1503 03.82 (P0403)